# EUROPEAN PATENT APPLICATION

(11) **EP 4 586 322 A1**
(43) Date of publication of application: **16.07.2025**
(21) Application number: 24757080.7
(22) Date of filing: 01.02.2024
(51) Int. Cl.: H01L 27/15, H01L 27/12, H01L 25/075, H01L 33/38

(54) **DISPLAY MODULE AND MANUFACTURING METHOD THEREOF**

(30) Priority: 14.02.2023 KR 20230019303
(71) Applicant: Samsung Electronics Co., Ltd., Suwon-si, Gyeonggi-do 16677 (KR)
(72) Inventor: MIN, Sungyong, Suwon-si Gyeonggi-do 16677 (KR); JANG, Kyungwoon, Suwon-si Gyeonggi-do 16677 (KR); KIM, Jinyoung, Suwon-si Gyeonggi-do 16677 (KR); CHUNG, Changkyu, Suwon-si Gyeonggi-do 16677 (KR)
(74) Representative: Appleyard Lees IP LLP
(86) International application number: PCT/KR2024/001498
(87) International publication number: WO 2024/172350

(57) **Abstract**

A display module is provided and includes a driving substrate; first electrodes on the driving substrate, and light-emitting diodes (LEDs) including: semi-conductor layers; second electrodes respectively corresponding to the first electrodes; protrusions on each of the second electrodes; and metal layers on the protrusions, each of the metal layers connected to one of the second electrodes. The display module further includes a non-conductive film layer between the driving substrate and the LEDs. The first electrodes and the second electrodes are connected by the metal layers.

## Description

### [TECHNICAL FIELD]

Embodiments of the present disclosure relate to a display module and a manufacturing method thereof and, more particularly, to a display module in which a light-emitting diode (LED) is stably connectable with a driving substrate and a manufacturing method thereof.

### [BACKGROUND ART]

Recently, technology for minimizing the size of an LED used for a display has been significantly developed. Particularly, recently, there is an increasing demand for technology capable of more efficiently connecting an electrode of an LED chip and an electrode on a driving substrate and improving the performance of the display module simultaneously.

In the related art, there is technology that an anisotropic conductive film (ACF) is laminated on a driving substrate, an LED chip is transferred, and then heat and pressure are applied to the entire driving substrate to cure the ACF, and a conductive ball in the ACF is used to electrically connect the electrode of the LED chip and the electrode on the driving substrate.

However, in the related art, since the ACF is laminated on the entire substrate, the conductive ball is entirely spread on an unnecessary area in addition to the area where the LED chip comes in contact with the driving substrate, thereby there is a problem in that a manufacturing cost increases. This is because a conductive ball occupying the largest percentage of the material ratio of the ACF is required to be more than necessary. In addition, in order to stably contact an LED chip (e.g., a micro LED chip) having a very small size to a driving substrate, a conductive ball inside the ACF should be uniformly aligned, so a manufacturing cost of ACF further increases.

In addition, according to the related art, as the LED chips become ultra-fine and have ultra-fine pitches, the electrodes of the LED chips become very narrow. In this case, when conductive balls are agglomerated or connected between the electrodes, this may cause failure in lighting of the LED chips due to a short defect.

In addition, according to the related art, in order to stably contact the LED chip with a very small size on the driving substrate, the conductive balls inside the ACF need to be uniformly aligned and the density of the conductive balls should be increased, but in this case, penetration of a lower electrode pattern is interfered by a conductive ball having high density and there is a problem in that vision alignment difficulty is increased during LED chip transfer.

### [TECHNICAL PROBLEM]

Embodiments of the present disclosure address the above-mentioned problems, and to provide a display module in which an LED may be stably connected to a driving substrate and a method of manufacturing thereof.

### [TECHNICAL SOLUTION]

According to embodiments of the present disclosure, a display module is provided and includes: a driving substrate; a plurality of first electrodes on the driving substrate; a plurality of light-emitting diodes (LEDs) including: a plurality of semi-conductor layers; a plurality of second electrodes respectively corresponding to the plurality of first electrodes; a plurality of protrusions on each of the plurality of second electrodes; and a plurality of metal layers on the plurality of protrusions, each of the plurality of metal layers connected to one of the plurality of second electrodes; and a non-conductive film layer between the driving substrate and the plurality of LEDs, wherein the plurality of first electrodes and the plurality of second electrodes are connected by the plurality of metal layers.

According to one or more embodiments of the present disclosure, the plurality of first electrodes and the plurality of second electrodes are connected by the plurality of first electrodes and the plurality of metal layers coming into contact via thermo-compression bonding of the non-conductive film layer.

According to one or more embodiments of the present disclosure, the non-conductive film layer is black.

According to one or more embodiments of the present disclosure, the plurality of protrusions comprise polymer having elastic recovery force.

According to one or more embodiments of the present disclosure, the plurality of protrusions comprise one from among a hemispherical shape, a conical shape, a pyramid shape, a triangular prism shape of which one cross section is in contact with one of the plurality of second electrodes, and a semi-cylindrical shape including a rectangular surface in contact with the one of the plurality of second electrodes.

According to one or more embodiments of the present disclosure, the plurality of LEDs further comprise a capping layer formed on the plurality of metal layers such as to prevent oxidation of the plurality of metal layers.

According to one or more embodiments of the present disclosure, the capping layer includes at least one from among indium-tin oxide (ITO), indium zinc oxide (IZO), and Au.

According to one or more embodiments of the present disclosure, the plurality of LEDs are flip-chip type LEDs that each have a horizontal length and a vertical length that are not less than 1*µ*m and not more than 100*µ*m.

According to embodiments of the present disclosure, a method of manufacturing a display module is provided and includes: forming a plurality of first electrodes on a driving substrate including circuitry; manufacturing a plurality of light-emitting diodes (LEDs) that includes a plurality of semi-conductor layers, a plurality of second electrodes respectively corresponding to the plurality of first electrodes, a plurality of protrusions on each of the plurality of second electrodes, and a plurality of metal layers on the plurality of protrusions, and each of the plurality of metal layers connected to one of the plurality of second electrodes; forming a non-conductive film layer on the driving substrate; transferring the plurality of LEDs onto the non-conductive film layer; and performing thermo-compression bonding of the non-conductive film layer so that the plurality of first electrodes and the plurality of second electrodes are connected by the plurality of first electrodes and the plurality of metal layers coming into contact with each other.

According to one or more embodiments of the present disclosure, the manufacturing the plurality of LEDs includes: forming the plurality of semi-conductor layers on a growth substrate; forming the plurality of second electrodes on the plurality of semi-conductor layers; forming an insulating organic film layer on the plurality of second electrodes; forming the plurality of protrusions by patterning the insulating organic film layer; and forming the plurality of metal layers on the plurality of protrusions.

According to one or more embodiments of the present disclosure, the non-conductive film layer is black.

According to one or more embodiments of the present disclosure, the plurality of protrusions comprise polymer having elastic recovery force.

According to one or more embodiments of the present disclosure, the plurality of protrusions include one from among a hemispherical shape, a conical shape, a pyramid shape, a triangular prism shape of which one cross section is in contact with one of the plurality of second electrodes, and a semi-cylindrical shape of which a rectangular cross section is in contact with the one of the plurality of second electrodes.

According to one or more embodiments of the present disclosure, the manufacturing the plurality of LEDs includes forming a capping layer on the plurality of metal layers such as to prevent oxidation of the plurality of metal layers.

According to one or more embodiments of the present disclosure, the capping layer includes at least one at least one from among indium-tin oxide (ITO), indium zinc oxide (IZO), and Au.

### [BRIEF DESCRIPTION OF DRAWINGS]

FIG. 1 is a view illustrating a structure of a display module according to an embodiment of the present disclosure.
FIG. 2 is an enlarged view of a portion of a display module according to an embodiment of the present disclosure.
FIGS. 3 and 4 illustrate details of protrusions and metal layers according to various embodiments of the present disclosure.
FIGS. 5 and 6 are views illustrating an LED and a metal layer formed on a protrusion according to various embodiments of the present disclosure.
FIG. 7 is a flowchart illustrating a method for manufacturing a display module according to an embodiment of the present disclosure.
FIGS. 8 to 11 are views illustrating respective steps of a method for manufacturing a display module according to an embodiment of the present disclosure.
FIG. 12 is a flowchart illustrating a method for manufacturing an LED according to an embodiment of the present disclosure.
FIGS. 13 to 15 are views illustrating each step of a method for manufacturing an LED according to an embodiment of the present disclosure.

### [MODE FOR INVENTION]

Hereinafter, non-limiting example embodiments of the present disclosure will be described with reference to the accompanying drawings. However, it may be understood that the present disclosure is not limited to the example embodiments described hereinafter, and also includes various modifications, equivalents, and/or alternatives of these example embodiments. In relation to explanation of the drawings, similar drawing reference numerals may be used for similar constituent elements.

In the following description, a detailed description of the related art may be omitted when it is determined that such description may obscure the gist of the present disclosure.

In addition, the following embodiments may be combined and modified in many different forms, and the scope of the technical spirit of the present disclosure is not limited to the following examples. Rather, these embodiments are provided so that this disclosure will be thorough and complete, and will fully convey the technical spirit to those skilled in the art.

The terms used herein are to describe certain embodiments and are not intended to limit the scope of the claims. A singular expression includes a plural expression unless otherwise specified.

In this specification, expressions such as "have," "may have," "include," "may include" or the like represent presence of a corresponding feature (e.g., components such as numbers, functions, operations, or parts) and does not exclude the presence of additional feature.

In this document, expressions such as "at least one of A [and/or] B," or "one or more of A [and/or] B," include all possible combinations of the listed items. For example, "at least one of A and B," or "at least one of A or B" includes any of (1) at least one A, (2) at least one B, or (3) at least one A and at least one B.

As used herein, the terms "first," "second," or the like may denote various components, regardless of order and/or importance, and may be used to distinguish one component from another, and does not otherwise limit the components.

If it is described that a certain element (e.g., first element) is "operatively or communicatively coupled with/to" or is "connected to" another element (e.g., second element), it should be understood that the certain element may be connected to the other element directly or through still another element (e.g., third element).

On the other hand, if it is described that a certain element (e.g., first element) is "directly coupled to" or "directly connected to" another element (e.g., second element), it may be understood that there is no element (e.g., third element) between the certain element and the another element.

Also, the expression "configured to" used in the present disclosure may be interchangeably used with other expressions such as "suitable for," "having the capacity to," "designed to," "adapted to," "made to," and "capable of," depending on cases. Meanwhile, the term "configured to" does not necessarily mean that a device is "specifically designed to" in terms of hardware.

Instead, under some circumstances, the expression "a device configured to" may mean that the device "is capable of" performing an operation together with another device or component. For example, the phrase "a processor configured to perform A, B, and C" may mean a dedicated processor (e.g., an embedded processor) for performing the corresponding operations, or a generic-purpose processor (e.g., a central processing unit (CPU) or an application processor) that can perform the corresponding operations by executing one or more software programs stored in a memory device.

According to an embodiment of the present disclosure, a module or a unit performs at least one function or operation, and can be implemented in hardware or software or a combination of hardware and software. In addition, a plurality of "modules" or a plurality of "units" may be integrated into at least one module except for "modules" or "units"' that need to be implemented in specific hardware, and may be implemented as at least one processor.

It is understood that various elements and regions in the figures may be shown out of scale. Accordingly, the scope of the present disclosure is not limited by the relative sizes or spacing in the accompanying drawings.

Hereinafter, with reference to the attached drawings, embodiments will be described in detail so that those skilled in the art to which the present disclosure belongs to can easily make and use the embodiments.

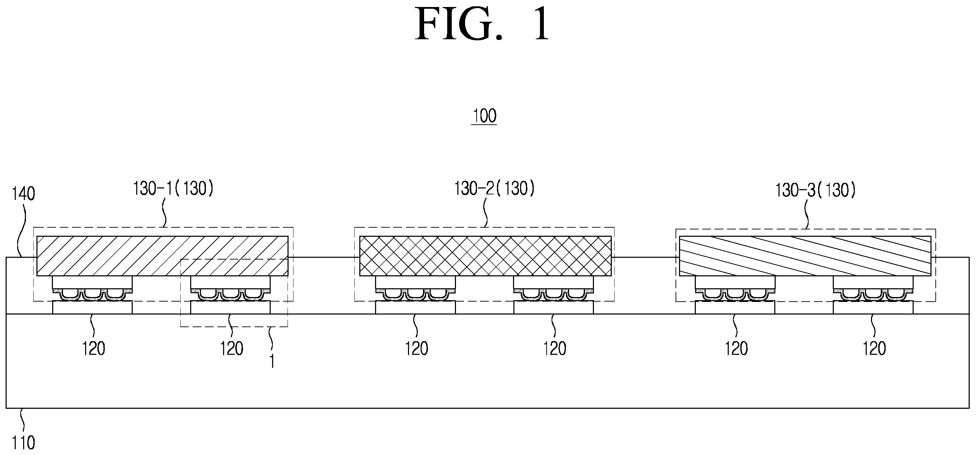

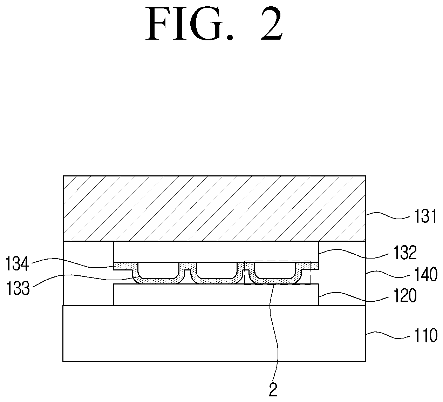

FIG. 1 is a view illustrating a structure of the display module 100 according to an embodiment of the present disclosure. FIG. 2 is an enlarged view of a region 1 of the display module 100 according to an embodiment of the present disclosure.

The display module 100 according to an embodiment of the present disclosure refers to a device capable of displaying an image. In particular, the display module 100 may be included in an electronic device and display an image. When the display module 100 is included in an electronic device, the display module 100 may display an image by control of a processor included in the electronic device.

The display module 100 according to an embodiment of the present disclosure may mean the entire display panel included in the electronic device or a plurality of the display module 100 may be combined to form one display panel. There is no specific limitation to a type of an electronic device to which the display module 100 of the present disclosure is applied.

Referring to FIG. 1, the display module 100 may include a driving substrate 110, a plurality of first electrodes 120, a plurality of LEDs 130, and a non-conductive film layer 140.

The driving substrate 110 refers to a substrate including a driving circuit for driving the plurality of LEDs 130. The driving substrate 110 may also be referred to as a circuit board. Specifically, a plurality of the LEDs 130 may be disposed on a driving substrate 110 including a driving circuit to be electrically connected to a driving circuit. The display module 100 may be driven in an active matrix type or a passive matrix type, and the driving circuit may be designed according to a driving method. The driving substrate 110 may be implemented in various types such as glass, a flexible printed circuit board (PCB), ceramic, or the like.

The driving circuit may be connected to the plurality of first electrodes 120 and may include a plurality of circuit elements such as a switching element. The switching element is a semiconductor element capable of controlling the driving of the plurality of LEDs 130 elements included in the display module 100, and serves as a kind of switch for individual pixels of the display device. For example, a thin film transistor (TFT) may be used as the switching element.

The plurality of first electrodes 120 may be formed on the driving substrate 110 to be connected to a driving circuit included in the driving substrate 110, and may be connected to a plurality of second electrodes 132 included in the plurality of LEDs 130 as described below. That is, the plurality of first electrodes 120 may serve to electrically connect the driving circuit and the plurality of LEDs 130. In the present disclosure, the term "first electrode" is used to distinguish the first electrodes 120 from the second electrodes 132 included in the LEDs 130 as described below, and may be replaced with terms such as the "first electrode pad," or the like.

The plurality of LEDs 130 may emit light by the control of the driving substrate 110. In this disclosure, the term "LEDs" may mean a plurality of LED chips in a state that packing process of a chip scale for the plurality of LEDs 130 has been completed.

In particular, as shown in FIG. 1, the plurality of LEDs 130 may be implemented in a flip-chip type in which a plurality of second electrodes 132 are arranged toward the opposite surface of the light emitting surface of the LEDs 130. In addition, the plurality of LED 130 may be implemented with micro LEDs having both horizontal and vertical lengths of 1-100 µm. However, the type of the plurality of LEDs 130 according to an embodiment of the present disclosure is not limited to a particular type.

Referring to FIG. 2 which is an enlarged view of the region 1 of FIG.1, each of the plurality of LEDs 130 according to an embodiment of the present disclosure may include a plurality of semiconductor layers 131, a plurality of second electrodes 132, a plurality of protrusions 133, and a plurality of metal layers 134.

Though not illustrated specifically, the plurality of semiconductor layers 131 may include an n-type semiconductor layer, a p-type semiconductor layer, and a light emitting layer.

The n-type semiconductor layer and the p-type semiconductor layer may be formed of a compound semiconductor such as an III-V group, an II-VI group, or the like. The n-type semiconductor layer and the p-type semiconductor layer may be formed of a nitride semiconductor layer. For example, the n-type semiconductor layer may be an n-gallium nitride (GaN) semiconductor layer and the p-type semiconductor layer may be a p-GaN semiconductor layer, although it is understood that one or more other embodiments are not limited thereto. That is, the n-type semiconductor layer and the p-type semiconductor layer may be made of various materials depending on the various characteristics required, designed, or used for the LEDs 130.

The n-type semiconductor is a semiconductor in which free electrons are used as a carrier for relocating charges, and may be formed by doping an n-type dopant such as Si, Ge, Sn, Te, or the like. The p-type semiconductor is a semiconductor in which a hole is used as a carrier for relocating charges and may be formed by doping a p-type dopant such as Mg, Zn, Ca, Ba, or the like.

The light-emitting layer, the n-type semiconductor layer, and the p-type semiconductor layer may be formed of various semiconductors having a band gap corresponding to a specific region within the spectrum. For example, a red LED 130 having a light wavelength of 600-750 nm may include one or more layers based on an AlInGaP-based semiconductor. At least some of the plurality of LEDs 130 may be implemented by a blue LED 130 having a light wavelength of 450-490 nm and a green LED having a light wavelength of 500-570 nm, which may each include one or more layers based on an AlInGaN-based semiconductor.

The three LEDs 130 shown in FIG. 1 are a red LED 130-1, a green LED 130-2, and a blue LED 130-3, respectively. The red LED 130-1, the green LED 130-2, and the blue LED 130-3 may implement one pixel of the display module 100, but the number and arrangement method of the LEDs 130 for each pixel according to an embodiment of the present disclosure are not limited to a particular configuration.

The light emitting layer is positioned between the n-type semiconductor layer and the p-type semiconductor layer, and is a layer in which electrons, which are carriers of the n-type semiconductor layer, meet holes, which are carriers of the p-type semiconductor layer. When electrons and holes meet in the light emitting layer, a potential barrier is formed by recombination of electrons and holes. When electrons and holes transition beyond a potential barrier to a low energy level according to the applied voltage, light of a corresponding wavelength is emitted.

Here, the light emitting layer may have a multi-quantum wells (MQW) structure, but embodiments of the present disclosure are not limited thereto, and the light emitting layer may have various structures such as a single-quantum well (SQW) structure or a quantum dot (QD) structure. When the light emitting layer is formed as the MQW structure, the well layer/barrier layer of the light emitting layer may be formed in a structure such as, but not limited to, InGaN/GaN, InGaN/InGaN, GaAs(InGaGs)/AlGaAs. The number of quantum wells included in the light emitting layer is not limited to a specific number.

A plurality of second electrodes 132 may be formed on the plurality of semiconductor layers 131 to be connected to the plurality of semiconductor layers 131, and may also be connected to a plurality of first electrodes 120 formed on the driving substrate 110. That is, the plurality of second electrodes 132 may be connected to the plurality of first electrodes 120 corresponding to the plurality of second electrodes 132 to electrically connect the driving circuit and the plurality of LEDs 130. In the present disclosure, the term "second electrode" is a term for distinguishing from the first electrodes 120 formed on the driving substrate 110, and may be replaced with terms such as a "second electrode pad."

A plurality of second electrodes 132 may include an n-type electrode connected to the n-type semiconductor layer and a p-type electrode connected to the p-type semiconductor layer. The n-type electrode and the p-type electrode may also be connected to one of the first electrodes 120. The number of second electrodes 132 connected to one of the LEDs 130 and the number of first electrodes 120 corresponding thereto are not limited to a particular configuration.

The plurality of protrusions 133 may refer to protruding features formed on each of the plurality of second electrodes 132. The plurality of protrusions 133 may include polymer having elastic recovery force. For example, the plurality of protrusions 133 may be made of a material such as polyimide (PI) or epoxy, and may be a material of a plurality of protrusions 133 according to an embodiment of the present disclosure if it is an insulating organic material having elastic recovery force. The plurality of protrusions 133 may be formed by forming an insulating organic film layer on the plurality of second electrodes 132 and patterning the formed insulating organic film layer.

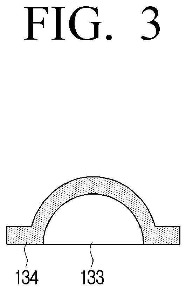

The plurality of protrusions 133 may be one of a hemispherical shape, a conical shape, and a pyramid shape. In addition, the plurality of protrusions may be a triangular prism shape of which one surface is in contact with one of the second electrodes 132, and a semi-cylindrical shape of which a rectangular surface is in contact with one of the second electrodes 132. A shape of the plurality of protrusions 133 will be described in detail with reference to FIGS. 3 to 6.

A plurality of metal layers 134 may be formed on the plurality of protrusions 133 and connected to the plurality of second electrodes 132. Specifically, each of the plurality of metal layers 134 may be formed on a plurality of protrusions 133, and may be connected to one of the second electrodes 132. In addition, the plurality of metal layers 134 may be connected to one of the first electrodes 120 by a thermo-compression bonding process as described below. That is, the plurality of metal layers 134 may serve to electrically connect the plurality of first electrodes 120 and the plurality of second electrodes 132. For example, the plurality of metal layers 134 may be formed of a metal such as Ti, Al, Cu, Ni, Au, or the like.

Although not illustrated in FIGS. 1 and 2, the plurality of LEDs 130 may further include a capping layer formed on the plurality of metal layers 134 to prevent oxidation of the plurality of metal layers 134. For example, the capping layer may be made of indium-tin oxide (ITO), indium zinc oxide (IZO), or Au.

Although not shown in FIGS. 1 and 2, the plurality of LED 130 may further include a reflective layer formed to reflect light emitted from the light-emitting layer toward the light-emitting surface direction of the LEDs 130 in order to increase the luminous efficiency of the LEDs 130. In addition, the plurality of LEDs 130 may further include an insulating layer for stabilizing device characteristics of the plurality of LEDs 130. In addition, various configurations for improving characteristics such as luminous efficiency of the plurality of LEDs 130 may be further included in the plurality of LEDs 130.

A non-conductive film (NCF) layer 140 may combine the driving substrate 110 and the plurality of LEDs 130. The non-conductive film layer 140 may be formed between the driving substrate 110 and the plurality of LEDs 130. The non-conductive film layer 140 may contact the plurality of first electrodes 120 and the plurality of metal layers 134 while being cured by thermo-compression bonding, thereby electrically connecting the plurality of first electrodes 120 and the plurality of second electrodes 132. That is, the plurality of first electrodes 120 and the plurality of second electrodes 132 may be connected through the plurality of metal layers 134. More specifically, the plurality of first electrodes 120 and the plurality of metal layers 134 may be connected as the plurality of first electrodes 120 and the plurality of metal layers 134 are in contact by thermo-compression bonding with respect to the non-conductive film layer 140.

In addition, the non-conductive film layer 140 may mechanically stabilize the plurality of LEDs 130 by filling a gap existing between the driving substrate 110 and the plurality of LEDs 130, and may perform a role of offsetting the mismatch of a coefficient of thermal expansion (CTE) between the driving substrate 110 and the plurality of LEDs 130, that is, an underfill. The material of the non-conductive film may be any thermosetting material capable of performing such underfill.

The non-conductive film layer 140 according to an embodiment of the present disclosure may be black. The non-conductive film layer 140 may be implemented with a transparent color, but when implemented with black, there is no need to form a black matrix (BM) formed on an upper portion of the plurality of LEDs 130 and thus, efficiency of the manufacturing process of the display module 100 may be improved.

It has been described that the plurality of protrusions 133 are formed on the plurality of second electrodes 132 included in the plurality of LEDs 130, the plurality of metal layers 134 are formed on the plurality of protrusions 133, and the plurality of first electrodes 120 and a plurality of second electrodes 132 are connected through the plurality of metal layers 134, but at least a part of the second electrodes 132 and the plurality of metal layers 134 may be integrated into one configuration.

For example, one of the second electrodes 132 that does not contact the semiconductor layer through a contact hole (via hole) of the plurality of second electrodes 132 may be implemented as one element integrated with one of the metal layers 134. For example, when a plurality of semiconductor layers 131 include an n-type semiconductor layer, a light-emitting layer, and a p-type semiconductor layer, which are sequentially stacked on a growth substrate, at least one of the protrusions 133 and at least one of the metal layers 134 are formed instead of a p-type electrode connected to the p-type semiconductor layer, so that the at least one of the metal layers 134 may replace the role of at least one of the second electrodes 132. When at least some of the plurality of second electrodes 132 are integrated with the plurality of metal layers 134 as described above, the efficiency of the manufacturing process of the display module 100 may be improved.

The display module 100 according to an embodiment of the present disclosure may be included in an electronic device to display an image under the control of a processor included in the electronic device. Specifically, the electronic device may include a display module 100, a memory for storing image data, and a processor for controlling the display module 100 to display an image based on the image data. Here, as described above, the display module 100 may include a driving substrate 110 (e.g., a circuit driving substrate), and a plurality of first electrodes 120 formed on the driving substrate 110. The display module 100 may include a plurality of semiconductor layers 131, a plurality of second electrodes 132 corresponding to each of the plurality of first electrodes 120, a plurality of protrusions 133 formed on each of the plurality of second electrodes 132, and a plurality of light-emitting diodes 130 formed on the plurality of protrusions 133 and each including a plurality of metal layers 134 connected to the plurality of second electrodes 132. In addition, the display module 100 may include a non-conductive film layer 140 formed between the driving substrate 110 and the plurality of LEDs 130, and the plurality of first electrodes 120 and the plurality of second electrodes 132 may be connected through the plurality of metal layers 134.

According to various embodiments as described above, in the display module 100, the first electrodes 120 included in the plurality of LEDs 130 are connected with the second electrodes 132 formed on the driving substrate 110 through the protrusions 133 and the metal layers 134 (the metal layers 134 of a protrusion type may be referred to as a metal protrusions) included in the plurality of LEDs 130, thereby stably connecting the plurality of LEDs 130 to the driving substrate 110, thereby significantly improving the stability for the performance of the display module 100 and the efficiency of the manufacturing process of the display module 100.

Specifically, when a metal protrusion is formed on an electrode of the LEDs 130, the efficiency of a manufacturing process may be remarkably improved and the manufacturing cost may be reduced as compared to a case in which the LEDs and a driving substrate are connected by using the conductive ball or a case in which a metal protrusion is formed on an electrode of the driving substrate as in a comparative embodiment. This is because a metal protrusion capable of contacting much larger number (e.g., several tens of) circuit boards may be formed on one wafer for the growth of a plurality of LEDs 130.

In addition, according to an embodiment of the present disclosure, the possibility of damage to the driving substrate 110 and the plurality of LEDs 130 may be significantly reduced in a manufacturing process compared to the case in which the protrusions 133 are formed on the electrode of the driving substrate 110. Since the material used in the driving substrate 110 and the material used in the process of forming the protrusions 133 are similar to each other, when a metal protrusion is formed on the electrode of the driving substrate 110, damage may occur to at least a portion of the driving substrate 110 and the LEDs 130 during the manufacturing process. In contrast, in the wafer for manufacturing the plurality of LEDs 130, an insulating organic material used for forming the protrusions 133 is not used and there is low possibility of damage.

According to embodiments of the present disclosure, when a defect occurs in some LEDs 130 compared to a related art of connecting a LED and a driving substrate by using a conductive ball, repair may be facilitated. Specifically, according to the related art of forming the conductive ball on a driving substrate, there is an extra region for facilitating repair when the LED is defective. However, since the conductive ball is formed in this region, it is difficult to replace the LED. In contrast, according to an embodiment of the present disclosure, it may be significantly easy to remove and replace one or more of the LEDs 130 including the metal layers 134, that are protruding, on the driving substrate 110, that is flat, by itself.

In addition, according to an embodiment of the present disclosure, compared to a case in which a metal protrusion is formed on an electrode of the driving substrate 110, the stability of a process for manufacturing the display module 100 may be remarkably improved due to high adhesive force between the plurality of LEDs 130 and the driving substrate 110, since when a metal protrusion is formed on the electrode of the driving substrate 110, a coupling between at least one of the second electrodes 132 included in the plurality of LEDs 130 and the non-conductive film layer 140 is performed. In contrast, when a metal protrusion is formed on the electrode of the plurality of LEDs 130 according to an embodiment of the present disclosure, a contact area in which coupling with the non-conductive film layer 140 is performed increases according to the metal protrusion. The stability of the process may be very effective in a transfer process in which precise transferring a micro chip to the driving substrate 110 is required.

The display module 100 according to an embodiment of the present disclosure can exhibit better performance compared to the related art since the range of the material that may be used in the wafer-side process for the growth of the plurality of LEDs 130 is wider than the material that may be used in the process of the driving substrate 110. For example, the kind of metal that may be used to prevent damage to a process is limited in the process of the driving substrate 110, whereas a metal having higher conductivity such as Au may be used when the metal layers 134 that are protruding are formed on the plurality of LEDs 130 according to an embodiment of the present disclosure.

According to the present disclosure, the production cost of the display module 100 may be remarkably reduced compared to the related art connecting a LED and a driving substrate 110 by using a conductive ball, and the same advantage of the stability of coupling between the LEDs 130 and the driving substrate 110 through the elastic recovery of the conductive ball may be maintained.

Moreover, according to an embodiment of the present disclosure, a metal protrusion between the LEDs 130 and the driving substrate 110 may be formed with higher uniformity and density compared to the related art for connecting a LED and a driving substrate by using a conductive ball, and a short defect due to a phenomenon in which conductive balls are agglomerated or connected between the electrodes may be minimized.

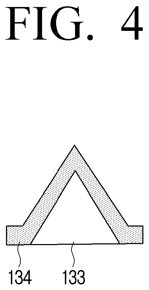

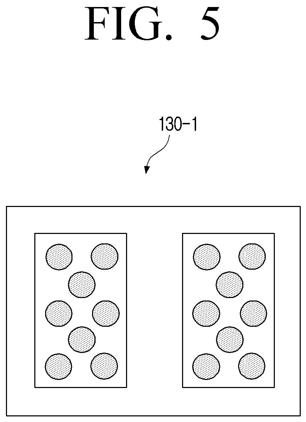

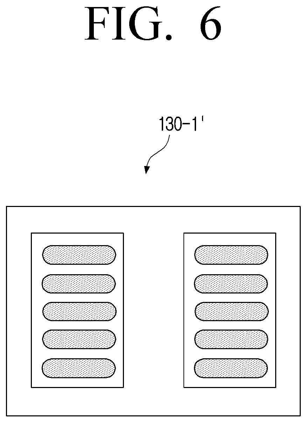

FIGS. 3 and 4 illustrate details of protrusions 133 and metal layers 134 according to various embodiments of the present disclosure. FIGS. 5 and 6 are views illustrating the LED 130 and one of the metal layers 134 formed on the protrusions 133 according to various embodiments of the present disclosure.

To be specific, FIGS. 3 and 4 are cross-sectional view of one of the protrusions 133 and one of the metal layers 134 according to an embodiment of the present disclosure, and FIGS. 5 and 6 are plan views (i.e., top view) illustrating one of the LEDs 130 and one of the the metal layers 134 formed on the protrusions 133.

As shown in FIG. 3, the protrusions 133 according to an embodiment of the present disclosure may have a hemispherical shape, and one of the metal layers 134 may be formed on the protrusions 133 and a surface of one of the second electrodes 132 (refer to FIG. 2). As shown in FIG. 4, the protrusions 133 according to an embodiment of the present disclosure may have a pyramid shape, and one of the metal layers 134 may be formed on the surface of the protrusions 133 and one of the second electrodes 132 (refer to FIG. 2).

The one of the protrusions 133, that is hemispherical, and the one of the metal layers 134 shown in FIG. 3 are shown as top views in FIG. 5. That is, the plurality of protrusions 133 having a hemispherical shape are disposed on one of the second electrodes 132 (refer to FIG. 2), and the one of the metal layers 134 may be formed on the surfaces of the plurality of protrusions 133 and the one of the second electrodes 132 (refer to FIG. 2).

As shown in FIG. 6, in a red LED 130-1' as a non-limiting example, a plurality of protrusions 133 (refer to FIG. 2) according to an embodiment of the present disclosure may be linearly disposed on one of the second electrodes 132, and may each have the form of a side lying semi-circular column. In addition, the one of the metal layers 134 may be formed on the surfaces of the plurality of protrusions 133 and one of the second electrodes 132 which are linearly arranged.

The plurality of protrusions 133 according to an embodiment of the present disclosure may have a so-called tapered structure whose width becomes narrower as it goes from down to up. For example, the plurality of protrusions 133 may easily form the one of the metal layers 134 on the entire surface of one of the second electrodes 132, including where the plurality of protrusions 133 are and are not disposed, when the width of the protrusions 133 gradually decreases upward.

According to embodiments of the present disclosure, it may be advantageous when the area where one of the metal layers 134 formed on the plurality of protrusions 133 meets one of the first electrodes 120 is narrower and the number is larger. In particular, when the area where the one of the metal layers 134 formed on the plurality of protrusions 133 meets the one of the first electrodes 120 is wide to have a shape of a line or a side, the contact between the one of the metal layers 134 and the one of the first electrodes 120 is less likely to be uniformly formed than when the area where the one of the metal layers 134 and the one of the first electrodes 120 formed on the plurality of protrusions 133 meet is narrow and the number is large, so the brightness and other performance aspects of each of the plurality of LEDs 130 may not be uniform. In addition, when the area where the one of the metal layers 134 formed on the plurality of protrusions 133 meets the one of the first electrodes 120 is wide, the distance between the one of the metal layers 134 and the one of the first electrodes 120 may be widened even if dust or the like is inserted into a part of the area.

Accordingly, the protrusions 133 and one of the metal layers 134 formed on the protrusions 133 according to an embodiment of the present disclosure may have a hemispherical shape as FIG. 5 or a pyramid shape as shown in FIG. 4, so that a region where the one of the metal layers 134 and the one of the first electrodes 120 meet each other may have a shape of a point, as opposed to a case in which a region where the one of the metal layers 134 meets the one of the first electrodes 120 has a line shape, as shown in FIG. 6.

The shape of the protrusions 133 and the metal layers 134 formed on the protrusions 133 according to an embodiment of the present disclosure are not limited to a specific shape, and the shape and size of the protrusions 133 and the metal layers 134 according to an embodiment of the present disclosure may be implemented in various shapes and sizes according to the size and structure of the LEDs 130.

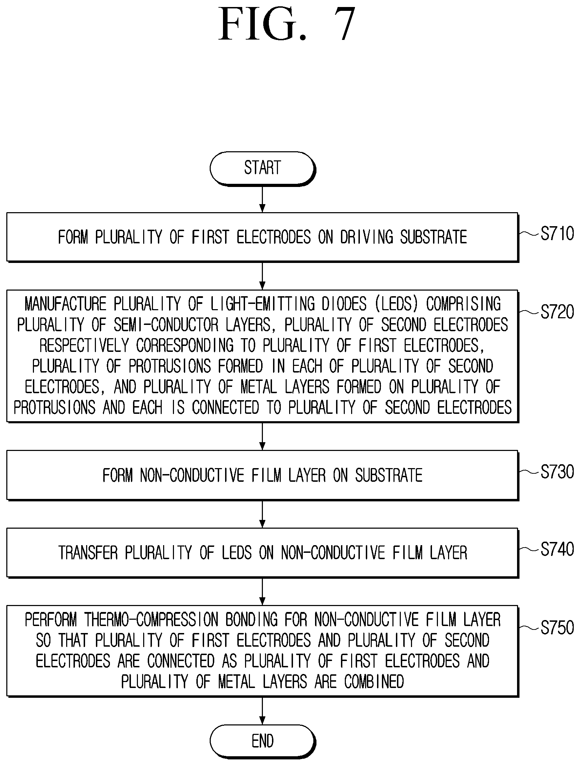

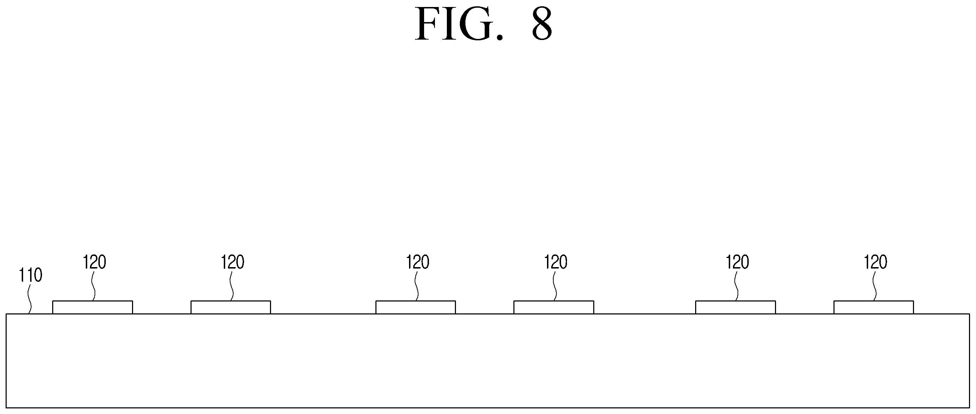

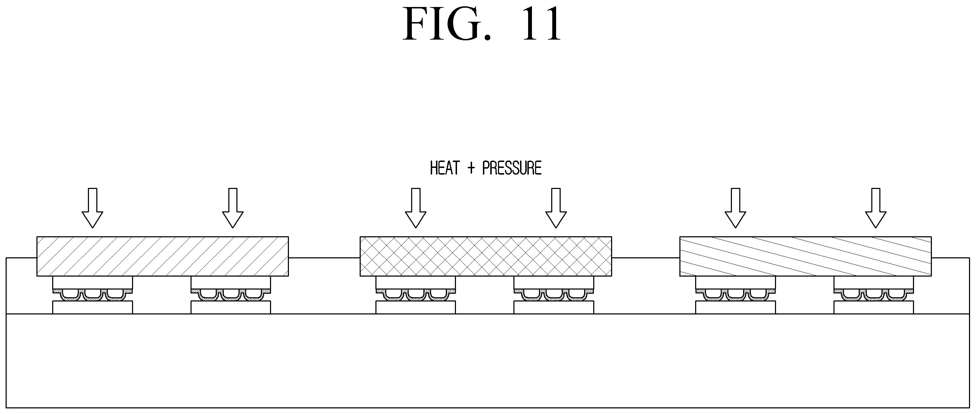

FIG. 7 is a flowchart illustrating a method for manufacturing the display module 100 according to an embodiment of the present disclosure. FIGS. 8 to 11 are views illustrating respective steps of a method for manufacturing the display module 100 according to an embodiment of the present disclosure. In the following drawings, reference numerals of some elements are omitted, which are only for clearly indicating the steps indicated by the corresponding drawings, and the omitted reference numerals may be easily understood based on the previous drawings of the present application.

A method for manufacturing the display module 100 according to an embodiment of the present disclosure may include an operation (operation S710) of forming a plurality of first electrodes 120 on the driving substrate 110. As shown in FIG. 8, a plurality of electrodes may be formed on a pre-designated region on the driving substrate 110.

The method for manufacturing the display module 100 according to an embodiment of the present disclosure may include an operation (operation S720) of manufacturing a plurality of LEDs 130 including a plurality of semiconductor layers 131, a plurality of second electrodes 132 respectively corresponding to the plurality of first electrodes 120, a plurality of protrusions 133 formed on each of the plurality of second electrodes 132, and a plurality of metal layers 134 formed on the plurality of protrusions 133 and connected to the plurality of second electrodes 132. The order between an operation of forming a plurality of first electrodes 120 on the driving substrate 110 in operation S710, and the operation of manufacturing the plurality of LEDs 130 in operation S720 may be reversed.

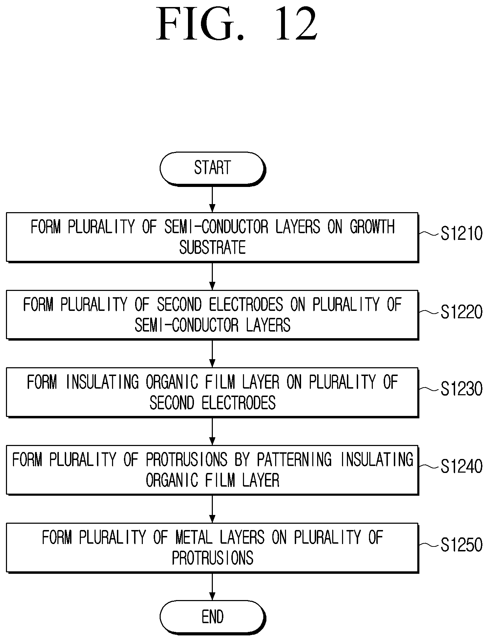

The operation of manufacturing a plurality of LEDs 130 may include forming a plurality of semiconductor layers 131, a plurality of second electrodes 132, a plurality of protrusions 133 and a plurality of metal layers 134 on a growth substrate (wafer), and also a chip scale packaging step. Individual operations for manufacturing the plurality of LEDs 130 are described in more detail with reference to FIGS. 12 to 15.

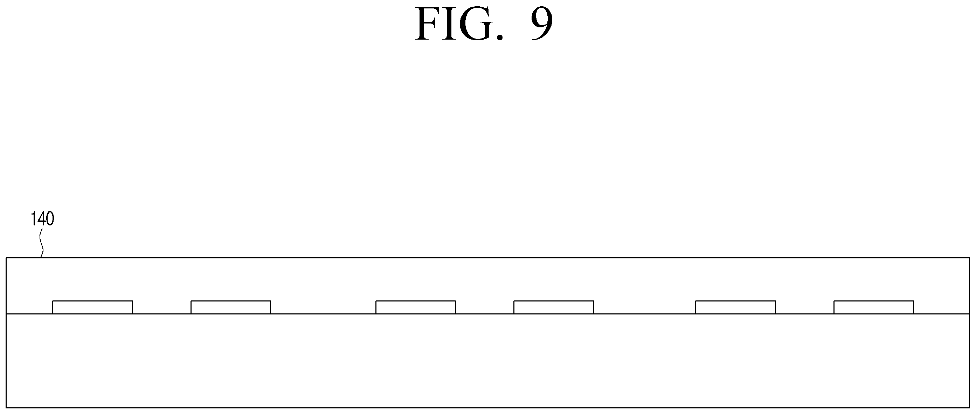

The method for manufacturing the display module 100 according to an embodiment of the present disclosure may include an operation (S730) of forming a non-conductive film layer 140 on a substrate. As shown in FIG. 9, the non-conductive film layer 140 may be formed on a surface on which a plurality of first electrodes 120 are not formed and a surface of a plurality of first electrodes 120 on the driving substrate 110.

Specifically, the non-conductive film layer 140 may be formed on the driving substrate 110 according to a so-called lamination process. The lamination process refers to a process of overlaying a layer (non-conductive film layer 140) on an object (driving substrate 110) to a subject by applying temperature and pressure. The lamination process may be used to protect the surface of an object to be subjected and increase strength and stability, and in particular, the non-conductive film layer 140 according to an embodiment of the present disclosure may be used for making a plurality of first electrodes 120 come into contact with a plurality of metal layers 134, as described below.

The method for manufacturing the display module 100 according to an embodiment of the present disclosure may include transferring a plurality of LEDs 130 onto the non-conductive film layer 140 in operation S740. Specifically, the plurality of LEDs 130 may be transferred onto the non-conductive film layer 140 by vision-aligning the plurality of first electrodes 120 formed on the driving substrate 110 and the second electrodes 132 included in the plurality of LEDs 130.

Specifically, when the step of manufacturing the plurality of LEDs 130 and the step of forming the non-conductive film layer 140 on the driving substrate 110 are completed, a process of transferring the plurality of LEDs 130 to the non-conductive film layer 140 formed on the driving substrate 110 may be performed. The transfer process according to an embodiment of the present disclosure may be performed by various methods such as an electrostatic method, a stamp method, a printing method, a metal bonding method, and the like, and there is no particular limitation in the method.

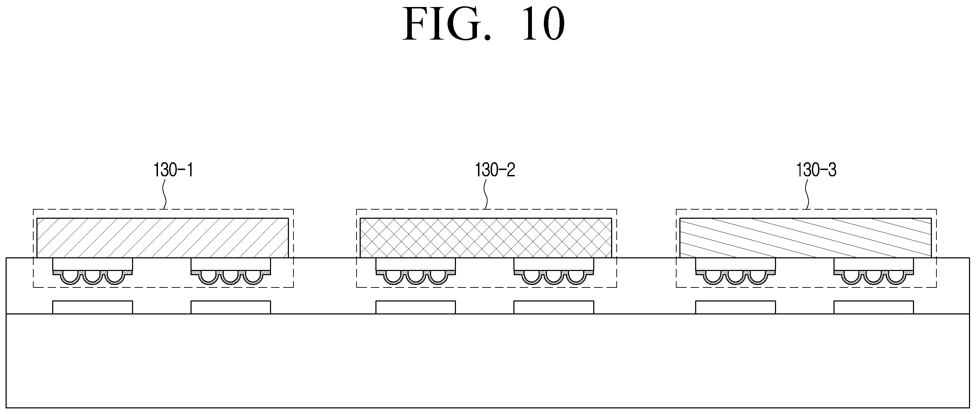

As shown in FIG. 10, a plurality of second electrodes 132 included in a plurality of LEDs 130 according to a transfer process may be disposed in a form of being embedded in the non-conductive film layer 140 on a plurality of first electrodes 120 corresponding thereto. In a state in which the transfer step is completed, a plurality of metal layers 134 formed on the plurality of protrusions 133 and a plurality of first electrodes 120 formed on the driving substrate 110 are not in contact with each other. The three LED 130 shown in FIG. 10 respectively are a red LED 130-1, a green LED 130-2, and a blue LED 130-3, but the number and arrangement method of the LEDs 130 for each pixel according to an embodiment of the present disclosure are not limited to a particular configuration.

A method of manufacturing a display module 100 according to an embodiment may include performing thermo-compression bonding for the non-conductive film layer 140 so that the plurality of first electrodes 120 and the plurality of second electrodes 132 are connected as the plurality of first electrodes 120 and the plurality of metal layers 134 are combined in operation S750.

Specifically, when a step of transferring a plurality of LEDs 130 onto the non-conductive film layer 140 is completed, heat and pressure are applied to the display module 100, particularly, the non-conductive film layer 140, and thus a plurality of metal layers 134 formed on the plurality of protrusions 133 and a plurality of first electrodes 120 formed on the driving substrate 110 come into contact with each other.

Then, when the non-conductive film layer 140 made of a thermosetting material is cured, the contact between the plurality of metal layers 134 formed on the plurality of protrusions 133 and the plurality of first electrodes 120 formed on the driving substrate 110 is maintained. In this case, since the plurality of protrusions 133 have an elastic recovery force to restore to the original shape in a state of being deformed by heat and pressure, the plurality of metal layers 134 and the plurality of first electrodes 120 may be more stably contacted.

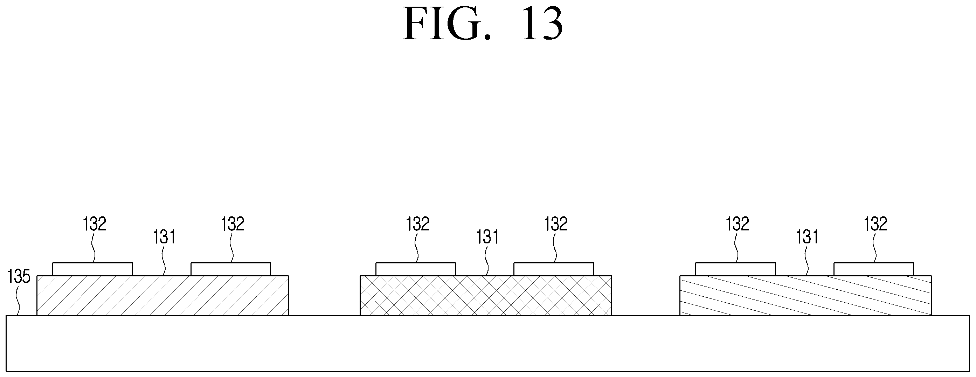

FIG. 12 is a flowchart illustrating a method for manufacturing the LEDs 130 according to an embodiment of the present disclosure. FIGS. 13 to 15 are views illustrating each step of a method for manufacturing the LED 130 according to an embodiment of the present disclosure.

The manufacturing method of the LEDs 130 according to an embodiment may include forming a plurality of semiconductor layers 131 in the growth substrate in operation S1210.

Specifically, when a growth substrate is provided, a plurality of semiconductor layers 131 such as an n-type semiconductor layer, a light-emitting layer, and a p-type semiconductor layer may be formed on a growth substrate. The process of forming the plurality of semiconductor layers 131 may be performed by a technique such as metal organic chemical vapor deposition (MOCVD), metal organic chemical vapor phase epitaxy (MOVPE), molecular beam epitaxy (MBE), or the like.

A method for manufacturing the LEDs 130 according to an embodiment of the present disclosure may include an operation S1220 of forming a plurality of second electrodes 132 on a plurality of semiconductor layers 131.

Specifically, although not shown in detail in FIG. 13, prior to forming a plurality of second electrodes 132 on the plurality of semiconductor layers 131, patterning for an area to be etched by a photoresist may be performed, and a step of patterning a region for forming the plurality of second electrodes 132 may be performed. The etching may be performed using dry etching techniques such as reactive ion etching (RIE), electro-cyclotron resonance (ECR), inductively coupled plasma reactive ion etching (ICP)-RIE, chemically assisted ion-beam etching (CAIBE), or the like.

When the operation S1210 of forming a plurality of semiconductor layers 131 and the operation S1220 of forming a plurality of second electrodes 132 are completed, a basic structure of a plurality of LEDs 130 may be formed on a growth substrate as shown in FIG. 13. Meanwhile, the growth substrate may be removed after the plurality of semiconductor layers 131 are formed.

The method of manufacturing the plurality of LEDs 130 according to an embodiment may include forming an insulating organic film layer on the plurality of second electrodes 132 in operation S1230; and forming the plurality of protrusions 133 by patterning the insulating organic film layer in operation S1240.

More specifically, a material having an elastic recovery force such as polyimide (PI) or epoxy may be used as a material of the insulating organic film layer, and the patterning of the insulating organic film layer means a process of allowing the insulating organic film layer to have one of various forms of the protrusions 133 as described above.

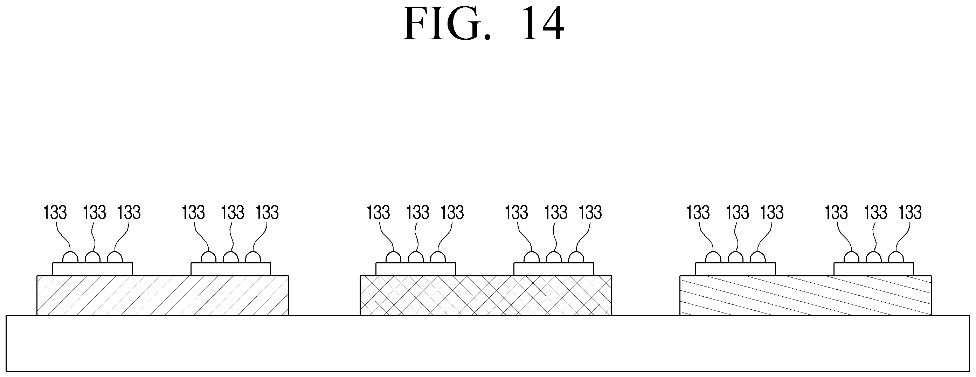

When a plurality of protrusions 133 are formed, a structure as shown in FIG. 14 is formed. When shown in a top view, one of the plurality of LEDs 130 shown in FIG. 14 may be represented by the top view shown in FIG. 5.

A method for manufacturing the LED 130 according to an embodiment of the present disclosure may include a step of forming a plurality of metal layers 134 on a plurality of protrusions 133 in operation S1250.

Specifically, the plurality of metal layers 134 may be formed of a metal such as, for example, Ti, Al, Cu, Ni, Au, or the like, and may be formed through a process such as physical vapor deposition (PVD).

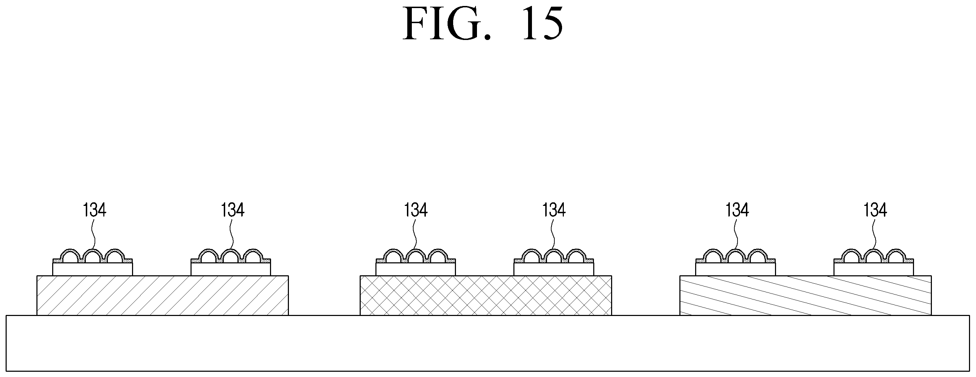

As shown in FIG. 15, when a plurality of protrusions 133 and a plurality of metal layers 134 are formed on a plurality of second electrodes 132 included in the plurality of LEDs 130, a chip-scale packaging step for the plurality of LEDs 130 is performed, and then a transfer step as described above with reference to FIGS. 7 and 10 may be performed.

Although not shown in FIG. 15, a step of forming a capping layer made of an oxide such as indium-tin oxide (ITO) and indium zinc oxide (IZO) or Au on the plurality of metal layers 134 may be additionally performed after the forming of the plurality of metal layers 134 in operation S1250.

According to various embodiments as described above, the display module 100 connects the first electrodes 120 included in the plurality of LEDs 130 with the second electrodes 132 formed on the driving substrate 110 through the protrusions 133 and the metal layers 134 included in the plurality of LEDs 130, thereby stably connecting the plurality of LEDs 130 to the driving substrate 110, and may significantly improve the stability for the performance of the display module 100 and the efficiency of the manufacturing process of the display module 100.

Each of the components (for example, a module or a program) according to one or more embodiments may be composed of one or a plurality of objects, and some subcomponents of the subcomponents described above may be omitted, or other subcomponents may be further included in the embodiments. Alternatively or additionally, some components (e.g., modules or programs) may be integrated into one entity to perform the same or similar functions performed by each respective component prior to integration. Further, various features from various different embodiments may be combined.

Operations performed by a module, program, or other component, in accordance with embodiments, may be performed sequentially, in parallel, repetitive, or heuristic manner, or at least some operations may be performed in a different order, omitted, or other operations may be added.

While non-limiting example embodiments of the present disclosure have been shown and described above with reference to drawings, it will be understood by those skilled in the art that various changes in form and details may be made therein without departing from the spirit and scope of the present disclosure.

## Claims

1. A display module comprising:
a driving substrate;
a plurality of first electrodes on the driving substrate;
a plurality of light-emitting diodes (LEDs) comprising:
a plurality of semi-conductor layers;
a plurality of second electrodes respectively corresponding to the plurality of first electrodes;
a plurality of protrusions on each of the plurality of second electrodes; and
a plurality of metal layers on the plurality of protrusions, each of the plurality of metal layers connected to one of the plurality of second electrodes; and
a non-conductive film layer between the driving substrate and the plurality of LEDs,
wherein the plurality of first electrodes and the plurality of second electrodes are connected by the plurality of metal layers.

2. The display module of claim 1, wherein the plurality of first electrodes and the plurality of second electrodes are connected by the plurality of first electrodes and the plurality of metal layers coming into contact via thermo-compression bonding of the non-conductive film layer.

3. The display module of claim 1, wherein the non-conductive film layer is black.

4. The display module of claim 1, wherein the plurality of protrusions comprise polymer having elastic recovery force.

5. The display module of claim 1, wherein the plurality of protrusions comprise one from among a hemispherical shape, a conical shape, a pyramid shape, a triangular prism shape of which one cross section is in contact with one of the plurality of second electrodes, and a semi-cylindrical shape comprising a rectangular surface in contact with the one of the plurality of second electrodes.

6. The display module of claim 1, wherein the plurality of LEDs further comprise a capping layer formed on the plurality of metal layers such as to prevent oxidation of the plurality of metal layers.

7. The display module of claim 6, wherein the capping layer comprises at least one from among indium-tin oxide (ITO), indium zinc oxide (IZO), and Au.

8. The display module of claim 1, wherein the plurality of LEDs are flip-chip type LEDs that each have a horizontal length and a vertical length that are not less than 1 *µ*m and not more than 100 *µ*m.

9. A method of manufacturing a display module, the method comprising:
forming a plurality of first electrodes on a driving substrate comprising circuitry;
manufacturing a plurality of light-emitting diodes (LEDs) that includes a plurality of semi-conductor layers, a plurality of second electrodes respectively corresponding to the plurality of first electrodes, a plurality of protrusions on each of the plurality of second electrodes, and a plurality of metal layers on the plurality of protrusions, and each of the plurality of metal layers connected to one of the plurality of second electrodes;
forming a non-conductive film layer on the driving substrate;
transferring the plurality of LEDs onto the non-conductive film layer; and
performing thermo-compression bonding of the non-conductive film layer so that the plurality of first electrodes and the plurality of second electrodes are connected by the plurality of first electrodes and the plurality of metal layers coming into contact with each other.

10. The method of claim 9, wherein the manufacturing the plurality of LEDs comprises:
forming the plurality of semi-conductor layers on a growth substrate;
forming the plurality of second electrodes on the plurality of semi-conductor layers;
forming an insulating organic film layer on the plurality of second electrodes;
forming the plurality of protrusions by patterning the insulating organic film layer; and
forming the plurality of metal layers on the plurality of protrusions.

11. The method of claim 9, wherein the non-conductive film layer is black.

12. The method of claim 9, wherein the plurality of protrusions comprise polymer having elastic recovery force.

13. The method of claim 9, wherein the plurality of protrusions include one from among a hemispherical shape, a conical shape, a pyramid shape, a triangular prism shape of which one cross section is in contact with one of the plurality of second electrodes, and a semi-cylindrical shape of which a rectangular cross section is in contact with the one of the plurality of second electrodes.

14. The method of claim 10, wherein the manufacturing the plurality of LEDs comprises forming a capping layer on the plurality of metal layers such as to prevent oxidation of the plurality of metal layers.

15. The method of claim 14, wherein the capping layer comprises at least one at least one from among indium-tin oxide (ITO), indium zinc oxide (IZO), and Au.
